# EUROPEAN PATENT APPLICATION

(11) **EP 4 723 120 A1**
(43) Date of publication of application: **08.04.2026**
(21) Application number: 25194439.3
(22) Date of filing: 06.08.2025
(51) Int. Cl.: G11C 16/26

(54) **MEMORY DEVICE PERFORMING CACHE LATCH INITIALIZATION OPERATION, MEMORY CONTROLLER FOR CONTROLLING THE SAME, AND CACHE LATCH INITIALIZATION METHOD THEREOF**

(30) Priority: 07.10.2024 KR 20240136083
(71) Applicant: Samsung Electronics Co., Ltd., Suwon-si, Gyeonggi-do 16677 (KR)
(72) Inventor: KANG, Kyoman, 16677 Suwon-si (KR)
(74) Representative: Marks & Clerk LLP

(57) **Abstract**

A memory device comprises a memory cell array including first and second planes; a page buffer circuit including first cache latches for storing data to be stored in the first plane and second cache latches for storing data to be stored in the second plane; and input/output lines for receiving a command and addresses from a memory controller. The command includes target plane information for initializing the first cache latches and/or the second cache latches. The memory device initializes only the cache latches corresponding to one or more target planes according to the command including the target plane information.

## Description

### BACKGROUND

Semiconductor memories may be classified as a volatile memory or a non-volatile memory, for example. Typically, volatile memories (e.g., a dynamic random access memory (DRAM) or a static random access memory (SRAM)) may exhibit faster read and/or write speeds when compared to non-volatile memory. However, data stored in volatile memory may disappear when a power applied to volatile memory is turned off. In contrast, non-volatile memory may retain the data even when the power is turned off.

A representative example of non-volatile memory may be a flash memory. Flash memory may store multi-bit data of two or more bits in one memory cell. Flash memory may have at least one erase state and a plurality of program (e.g., writing) states depending on threshold voltage distributions.

A flash memory may include a large number of cache latches in a page buffer circuit. When the flash memory initializes a large number of cache latches simultaneously before a program operation, a large peak current may occur. In order to reduce the peak current, the number of cache latches must be divided into several units and initialized sequentially. This method requires a lot of initialization time. However, the time required for the flash memory to initialize cache latches is limited.

A conventional flash memory starts initializing cache latches when a command is input, and initializes cache latches for all planes without checking the addresses. Since cache latches are initialized for all planes, peak current and power noise may occur significantly. This problem may become more severe as the number of planes increases.

### SUMMARY

In general, in some aspects, the present disclosure is directed toward a memory device that receives target plane information during a program operation and performs a cache latch initialization operation that reduces peak current by selectively initializing cache latches according to the target plane information.

According to some implementations, the present disclosure is directed to a memory device that comprises a memory cell array including first and second planes; a page buffer circuit including first cache latches for storing data to be stored in the first plane and second cache latches for storing data to be stored in the second plane; and input/output lines for receiving a command and addresses from a memory controller, wherein the command includes target plane information for initializing the first cache latches and/or the second cache latches.

According to some implementations, the present disclosure is directed to a memory controller for controlling a memory device, the memory device comprising a memory cell array including first and second planes; a page buffer circuit including first cache latches for storing data to be stored in the first plane and second cache latches for storing data to be stored in the second plane; and a cache latch control logic configured to provide a first cache latch initialization signal for initializing the first cache latches and a second cache latch initialization signal for initializing the second cache latches to the page buffer circuit, wherein the memory controller is configured to provide a command including target plane information to the memory device during a program operation, and wherein at least one of the first cache latches and the second cache latches are selectively initialized according to the target plane information.

According to some implementations, the present disclosure is directed to a cache latch initialization method of a memory device connected to a memory controller through input/output lines, wherein the memory device comprises: a memory cell array including first to n-th planes; a page buffer circuit including first to n-th cache latches, first cache latches configured to store data to be stored in the first plane, and the n-th cache latches configured to store data to be stored in the n-th plane; a cache latch control logic configured to generate first to n-th cache latch initialization signals, the first cache latch initialization signal for initializing the first cache latches, the n-th cache latch initialization signal for initializing the n-th cache latches, and to provide the first to n-th cache latch initialization signals to the page buffer circuit, and wherein the method comprises: receiving target plane information during a program operation; and providing the first cache latch initialization signal to the first cache latches and/or the n-th cache latch initialization signal to the n-th cache latches according to the target plane information.

At least some of the above and other features of the invention are set out in the claims.

### BRIEF DESCRIPTION OF THE DRAWINGS

Example implementations will be more clearly understood from the following detailed description, taken in conjunction with the accompanying drawings.
FIG. 1 is a block diagram illustrating an example of a storage device according to some implementations, the storage device including a memory device and a memory controller.
FIG. 2 is a block diagram illustrating an example of the memory device illustrated in FIG. 1 according to some implementations.
FIG. 3 is a circuit diagram illustrating an example of a memory block BLK1 of a memory cell array of the memory device illustrated in FIG. 2 according to some implementations.
FIG. 4 is a circuit diagram illustrating examples of cell strings selected by a first string selection line SSL1 from among the cell strings of the memory block BLK1 illustrated in FIG. 3 according to some implementations.
FIG. 5 is a diagram illustrating an example of threshold voltage distributions of memory cells illustrated in FIG. 4 according to some implementations.
FIG. 6 is a circuit diagram illustrating an example of a first page buffer PB1 of a first page buffer circuit of the memory device shown in FIG. 2 according to some implementations.
FIG. 7 is a circuit diagram illustrating an example of a cache latch CL of the first page buffer PB1 illustrated in FIG. 6 according to some implementations.
FIG. 8 is a block diagram illustrating an example of a cache latch initialization operation of a memory device according to some implementations.
FIG. 9 is a flowchart illustrating an example of the cache latch initialization operation of the memory device illustrated in FIG. 8 according to some implementations.
FIGS. 10 to 15 are timing diagrams illustrating an example of the cache latch initialization operation of the memory device illustrated in FIG. 9 according to some implementations.
FIGS. 16A to 16D are block diagrams illustrating examples of memory devices including various numbers of planes according to some implementations.
FIG. 17 is a diagram illustrating examples of peak currents generated during a program operation of the memory devices illustrated in FIGS. 16A to 16D according to some implementations.
FIGS. 18 to 21 are diagrams illustrating an example of the cache latch initialization operation of the memory device illustrated in FIG. 16C according to some implementations.
FIG. 22 is a diagram illustrating an example of a memory device having a multi-stack structure according to some implementations.
FIG. 23 is a block diagram illustrating an example in which a storage device is implemented with a solid state drive SSD according to some implementations.

### DETAILED DESCRIPTION

Hereinafter, example implementations will be explained in detail with reference to the accompanying drawings.

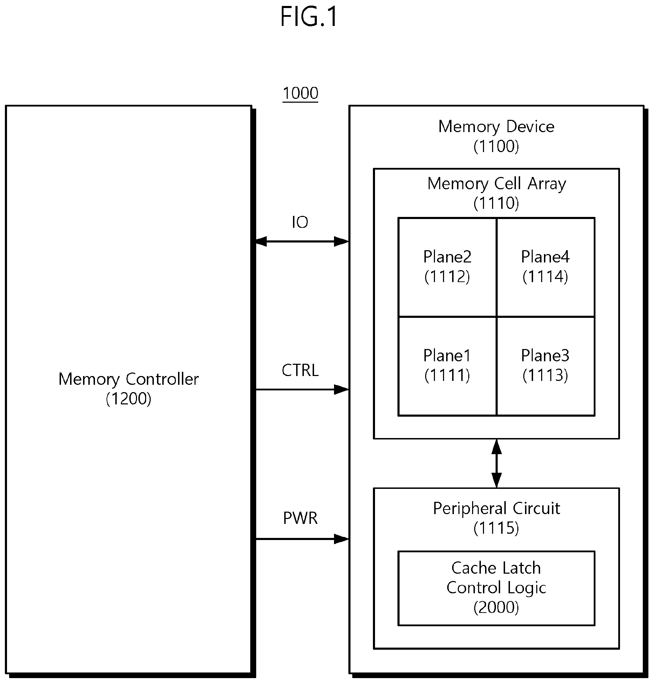

FIG. 1 is a block diagram illustrating an example of a storage device according to some implementations. In FIG. 1, the storage device 1000 may be a flash storage device based on a flash memory. For example, the storage device 1000 may be implemented as a solid-state drive (SSD), a universal flash storage (UFS), a memory card, or the like.

In FIG. 1, the storage device 1000 may include a memory device 1100 and a memory controller 1200. The memory device 1100 may receive input/output signals IO from the memory controller 1200 through input/output lines, receive control signals CTRL through control lines, and receive external power supply PWR through power lines. The storage device 1000 may store data in the memory device 1100 under the control of the memory controller 1200.

The memory device 1100 may include a memory cell array 1110 and a peripheral circuit 1115. The memory cell array 1110 may have a vertical 3D structure. The memory cell array 1110 may include a plurality of planes. For example, the memory cell array 1110 may include first to fourth planes 1111 to 1114. Each plane may include a plurality of memory cells. Single-bit data or multi-bit data may be stored in each memory cell.

In some implementations, the memory cell array 1110 may be located (e.g., disposed) next to or above the peripheral circuit 1115 in terms of the design layout structure. A structure in which the memory cell array 1110 is positioned over the peripheral circuit 1115 may be referred to as a cell on peripheral (COP) structure.

In some implementations, the memory cell array 1110 may be manufactured as a chip separate from the peripheral circuit 1115. An upper chip including the memory cell array 1110 and a lower chip including the peripheral circuit 1115 may be connected to each other by a bonding method. Such a structure may be referred to as a chip-to-chip (C2C) structure.

The peripheral circuit 1115 may include analog circuits and/or digital circuits required to store data in the memory cell array 1110 or read data stored in the memory cell array 1110. The peripheral circuit 1115 may receive the external power PWR through power lines and generate internal powers of various levels.

The peripheral circuit 1115 may receive commands, addresses, and/or data from the memory controller 1200 through input/output lines. The peripheral circuit 1115 may store data in the memory cell array 1110 according to the control signals CTRL. Additionally, the peripheral circuit 1115 may read data stored in the memory cell array 1110 and provide the read data to the memory controller 1200.

The peripheral circuit 1115 may include a large number of cache latches therein. When the memory device 1100 initializes a large number of cache latches simultaneously, a large peak current may occur. In order to reduce the peak current, it is necessary to divide the number of cache latches into several units and sequentially initialize them. A large initialization time may be required to perform this. However, the time from command input to data loading is fixed.

The peripheral circuit 1115 may include a cache latch control logic 2000. The cache latch control logic 2000 may perform a cache latch initialization operation during a program operation. The cache latch control logic 2000 may receive target plane information during a program operation and selectively initialize only the cache latches of target planes according to the target plane information, thereby reducing the peak current.

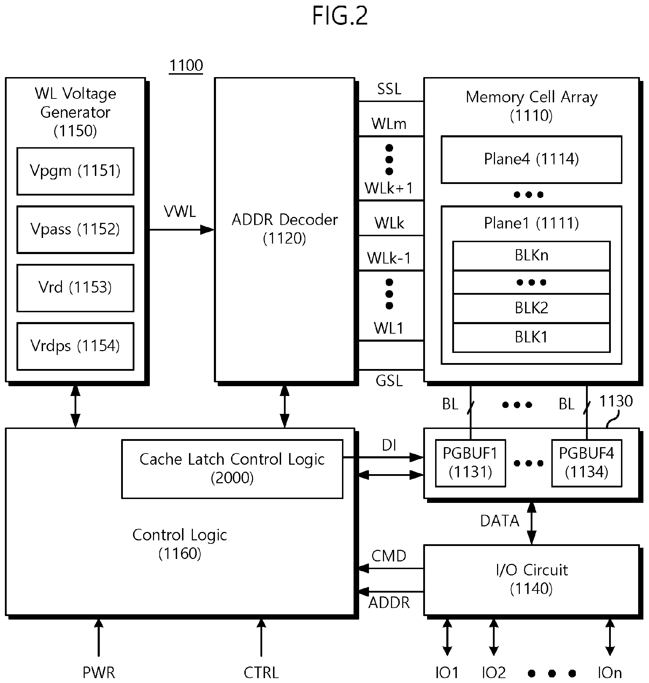

FIG. 2 is a block diagram illustrating an example of the memory device illustrated in FIG. 1 according to some implementations. In FIG. 2, the memory device 1100 may include the memory cell array 1110 and the peripheral circuit 1115 (see FIG. 1). The peripheral circuit 1115 may include an address decoder 1120, a page buffer circuit 1130, a data input/output circuit 1140, a word line voltage generator 1150, and a control logic 1160.

The memory cell array 1110 may include a plurality of planes. For example, the memory cell array 1110 may include first to fourth planes 1111 to 1114. The first plane 1111 may include a plurality of memory blocks BLK1 to BLKn. Each memory block may include a plurality of pages. Each page may include a plurality of memory cells. Each memory cell may store multi-bit data (e.g., two or more bits). Each memory block may correspond to an erase unit, and each page may correspond to a read unit and/or a write unit.

The memory cell array 1110 may be formed in a direction perpendicular to a substrate. A gate electrode layer and an insulation layer may be alternately deposited on the substrate. Each memory block (e.g., BLK1) may be connected to one or more string selection lines SSL, a plurality of word lines WL1 to WLm, and one or more ground selection lines GSL. WLk is a selected word line sWL and the remaining word lines (WL1 to WLk-1, WLk+1 to WLm) are unselected word lines uWL.

The address decoder 1120 may be connected to the memory cell array 1110 through selection lines SSL and GSL and word lines WL1 to WLm. The address decoder 1120 may select a word line during a program or read operation. The address decoder 1120 may receive the word line voltage VWL from the word line voltage generator 1150 and provide a program voltage or read voltage to the selected word line.

The page buffer circuit 1130 may be connected to the memory cell array 1110 via bit lines BL. The page buffer circuit 1130 may include first to fourth page buffer circuits 1131 to 1134. The first page buffer circuit (PGBUF1, 1131) may be connected to the first plane 1111 via bit lines BL. Similarly, the fourth page buffer circuit (PGBUF4, 1134) may be connected to the fourth plane 1114 via bit lines BL.

The page buffer circuit 1130 may temporarily store data to be stored in the memory cell array 1110 or data read from the memory cell array 1110. The page buffer circuit 1130 may include page buffers connected to respective bit lines. Each page buffer may include a plurality of latches to store or read multi-bit data.

The input/output circuit 1140 may be internally connected to the page buffer circuit 1130 through data lines and externally connected to the memory controller 1200 (refer to FIG. 1) through the input/output lines IO1 to IOn. The input/output circuit 1140 may receive program data from the memory controller 1200 during a program operation. Also, the input/output circuit 1140 may provide data read from the memory cell array 1110 to the memory controller 1200 during a read operation.

The word line voltage generator 1150 may receive internal power from the control logic 1160 and generate a word line voltage VWL required to read or write data. The word line voltage VWL may be provided to a selected word line sWL or unselected word lines uWL through the address decoder 1120.

The word line voltage generator 1150 may include a program voltage generator 1151 and a pass voltage generator 1152. The program voltage generator 1151 may generate a program voltage Vpgm provided to the selected word line sWL during a program operation. The pass voltage generator 1152 may generate a pass voltage Vpass provided to the selected word line sWL and the unselected word lines uWL.

The word line voltage generator 1150 may include a read voltage generator 1153 and a read pass voltage generator 1154. The read voltage generator 1153 may generate a select read voltage Vrd provided to the select word line sWL during a read operation. The read pass voltage generator 1154 may generate a read pass voltage Vrdps provided to unselected word lines uWL. The read pass voltage Vrdps may be a voltage sufficient to turn on memory cells connected to the unselected word lines uWL during a read operation.

The control logic 1160 may control operations, such as read, write, and erase, of the memory device 1100 using commands CMD, addresses ADDR, and control signals CTRL provided from the memory controller 1200. The addresses ADDR may include a block selection address for selecting one memory block, a row address for selecting one page, and a column address for selecting one memory cell.

The memory device 1100 may include a large number of cache latches. For example, each plane may include 16KB of cache latches. That is, the number of first cache latches CL1 of the first page buffer (PGBUF1, 1131) may be 16KB. The number of second to fourth cache latches CL2 to CL4 may each be 16 KB. When the memory device 1100 initializes a large number of cache latches simultaneously, a large peak current may occur. In order to reduce the peak current, it is necessary to divide the number of cache latches into several units and sequentially initialize them. A large initialization time may be required to perform this.

However, the time from command input to data loading is limited. The time required for the memory device 1100 to perform a cache latch initialization operation is limited. The memory device 1100 receives a command, addresses, and data. If the memory device 1100 attempts to initialize the cache latches before receiving an address and loading data, the initialization operation may not be completed within the limited time.

Accordingly, cache latches begin to be initialized immediately when a command is input. The memory device initializes the cache latches of all planes without checking the addresses. Because the cache latches of all planes are initialized, peak current and power noise may be large, and may become more severe as the number of planes increases.

The memory device 1100 may include cache latch control logic 2000. The cache latch control logic 2000 may reduce peak current by receiving target plane information during program operation and selectively initializing only the cache latches of the target planes according to the target plane information.

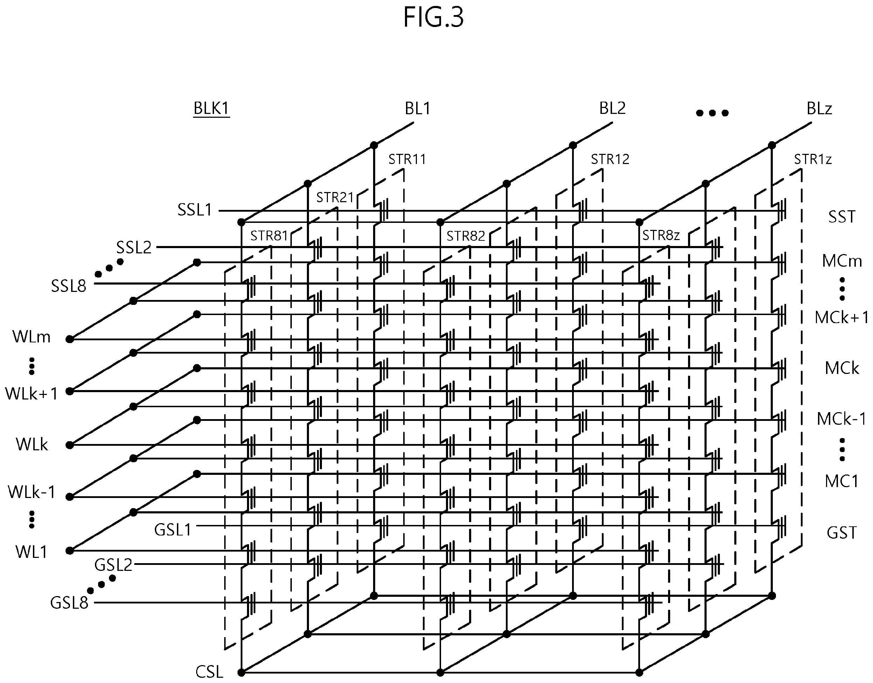

FIG. 3 is a circuit diagram illustrating an example of a memory block BLK1 of the memory cell array illustrated in FIG. 2 according to some implementations. In FIG. 3, in the memory block BLK1, a plurality of cell strings STR11 to STR8z may be formed between the bit lines BL1 to BLz and a common source line CSL. Each cell string includes a string selection transistor SST, a plurality of memory cells MC1 to MCm, and a ground selection transistor GST.

The string selection transistors SST may be connected with string selection lines SSL1 to SSL8. The ground selection transistors GST may be connected with ground selection lines GSL1 to GSL8. The string selection transistors SST may be connected with the bit lines BL1 to BLz, and the ground selection transistors GST may be connected with the common source line CSL.

The first to m-th word lines WL1 to WLm may be connected with the plurality of memory cells MC1 to MCm in a row direction. The first to z-th bit lines BL1 to BLz may be connected with the plurality of memory cells MC1 to MCm in a column direction. First to z-th page buffers PB1 to PBz may be connected with the first to z-th bit lines BL1 to BLz.

The first word line WL1 may be placed above the first to eighth ground selection lines GSL1 to GSL8. The first memory cells MC1 that are placed at the same height from the substrate may be connected with the first word line WL1. The m-th word line WLm may be located below the first to eighth string selection lines SSL1 to SSL8. The m-th memory cells MCm located at the same height from the substrate may be connected to the m-th word line WLm. In a similar manner, the second to (m-1)-th memory cells MC2 to MCm-1 that are placed at the same heights from the substrate may be respectively connected with the second to (m-1)-th word lines WL2 to WLm-1, respectively.

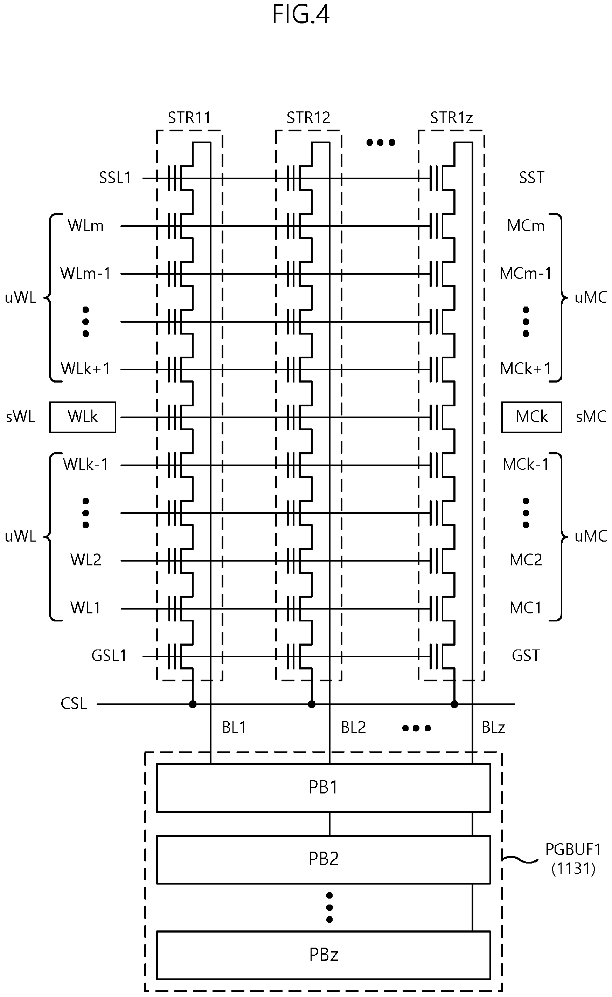

FIG. 4 is a circuit diagram illustrating examples of cell strings selected by the first string selection line SSL1 from among the cell strings of the memory block BLK1 illustrated in FIG. 3 according to some implementations. In FIG. 4, the 11th to 1z-th cell strings STR11 to STR1z may be selected by the first string selection line SSL1. The 11th to 1z-th cell strings STR11 to STR1z may be connected to the first to z-th bit lines BL1 to BLz, respectively. The first to z-th page buffers PB1 to PBz may be connected to the first to z-th bit lines BL1 to BLz, respectively.

The 11th cell string STR11 may be connected to the first bit line BL1 and the common source line CSL. The 11th cell string STR11 may include string selection transistors SST selected by the first string selection line SSL1, first to m-th memory cells MC1 to MCm connected to the first to m-th word lines WL1 to WLm, and ground selection transistors GST selected by the first ground selection line GSL1. The 12th cell string STR12 may be connected to the second bit line BL2 and the common source line CSL. The 1z cell string STR1z may be connected to the z-th bit line BLz and the common source line CSL.

The first word line WL1 and the m-th word line WLm may be edge word lines (edge WL). The second word line WL2 and the (m-1)-th word line WLm-1 may be edge adjacent word lines. The k-th word line WLk may be a selected word line sWL. The (k-1)-th word line WLk-1 and the (k+1)-th word line WLk+1 may be adjacent word lines adjacent to the selected word line. If the k-th word line WLk is the selected word line sWL, the remaining word lines WL1 to WLk-1 and WLk+1 to WLm may be unselected word lines uWL.

The first memory cells MC1 and the m-th memory cells MCm may be edge memory cells. The second memory cells MC2 and the (m-1)-th memory cells MCm-1 may be edge adjacent memory cells. The k-th memory cells MCk may be selected memory cells sMC. The (k-1)-th memory cells MCk-1 and the (k+1)-th memory cells MCk+1 may be memory cells adjacent to the selected memory cells (adjacent MC). If the k-th memory cells MCk are selected memory cells sMC, the remaining memory cells MC1 to MCk-1 and MCk+1 to MCm may be unselected memory cells uMC.

A set of memory cells selected by one string selection line and connected to one word line may be one page. For example, memory cells selected by the first string selection line SSL1 and connected to the k-th word line WLk may be one page. For example, eight pages may be configured on the k-th word line WLk. Among the eight pages, a page connected to the first string selection line SSL1 is a selected page, and pages connected to the second to eighth string selection lines SSL2 to SSL8 are unselected pages.

The first word line WL1 is a first edge word line (Edge1 WL), and the second word line WL2 is a first edge adjacent word line (Edge1 adjacent WL). The m-th word line WLm is the second edge word line (Edge2 WL), and the (m-1)-th word line WLm-1 is the second edge adjacent word line (Edge2 adjacent WL). And word lines between the first and second edge adjacent word lines are middle word lines. For example, the k-th word line WLk (k = 3 to m-2) between the second word line WL2 and the (m-1)-th word line WLm-1 is a middle word line.

In the read operation, if the second word line WL2 is the selected word line sWL, the remaining word lines may be unselected word lines uWL. The second word line WL2 may be a first edge adjacent word line (Edge1 adjacent WL). The second memory cells MC2 may be selected memory cells sMC. The remaining memory cells may be unselected memory cells uMC.

If the (m-1)-th word line WLm-1 is the selected word line sWL, the remaining word lines may be unselected word lines uWL. The (m-1)-th word line WLm-1 may be a second edge adjacent word line. The (m-1)-th memory cells MCm-1 may be selected memory cells sMC. The remaining memory cells may be unselected memory cells uMC.

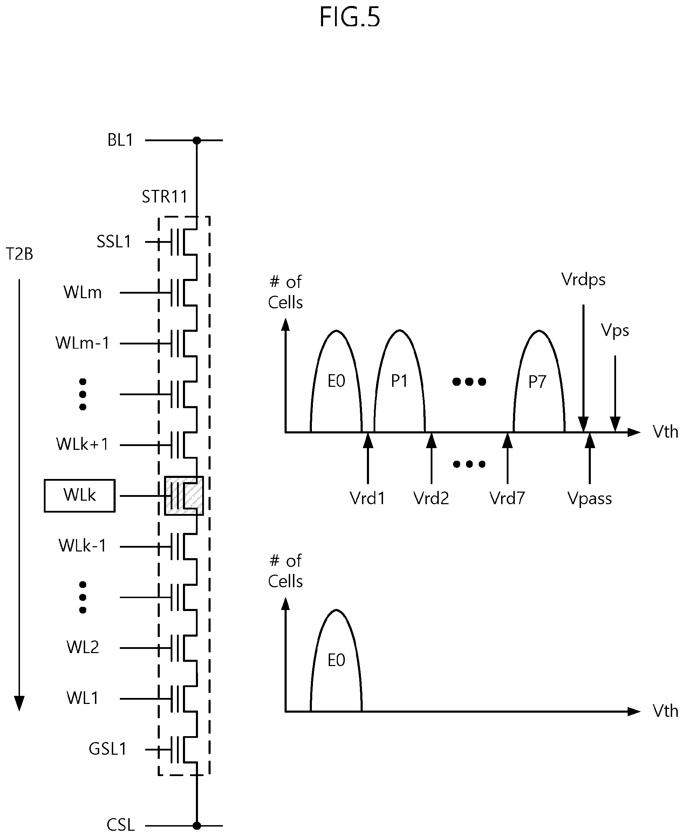

FIG. 5 is a diagram illustrating an example of threshold voltage distributions of memory cells illustrated in FIG. 4 according to some implementations. An abscissa denotes a threshold voltage Vth of a memory cell, and an ordinate denotes the number of memory cells. 3-bit data may be stored in one memory cell. A 3-bit memory cell may have one of eight states (E0, P1 to P7) according to the threshold voltage distribution. E0 represents an erase state, and P1 to P7 represent program states.

During a read operation, the selection read voltages Vrd1 to Vrd7 may be provided to the selected word line sWL, and the pass voltage Vps and/or the read pass voltage Vrdps may be provided to the unselected word lines uWL. The pass voltage Vps and/or the read pass voltage Vrdps may be a voltage sufficient to turn on the memory cells. For example, the pass voltage Vps may be provided to the adjacent word lines WLk±1, and the read pass voltage Vrdps may be provided to the unselected word lines other than the adjacent word lines.

The first selection read voltage Vrd1 may be a voltage level between the erase state E0 and the first program state P1. The second selection read voltage Vrd2 may be a voltage level between the first and second program states P1 and P2. In this way, the seventh selection read voltage Vrd7 may be a voltage level between the sixth and seventh program states P6 and P7.

When the first selection read voltage Vrd1 is applied, the memory cell in the erase state E0 may be an on cell and the memory cell in the first to seventh program states P1 to P7 may be an off cell. When the second selection read voltage Vrd2 is applied, the memory cell in the erase state E0 and the first program state P1 may an on cell, and the memory cell in the second to seventh program states P2 to P7 may an off cell. In this way, when the seventh selection read voltage Vrd7 is applied, the memory cell in the erase state E0 and the first to sixth program states P1 to P6 may be an on cell and the memory cell in the seventh program state P7 may be an off cell.

During a read operation, the k-th word line WLk may be selected. A power supply voltage may be applied to the string selection line SSL1 and the ground selection line GSL1, and the string select transistor SST and the ground select transistor GST may be turned on. Also, the selection read voltage Vrd may be provided to the selected word line sWL, and the read pass voltage Vrdps and/or the pass voltage Vps may be provided to the unselected word lines uWL.

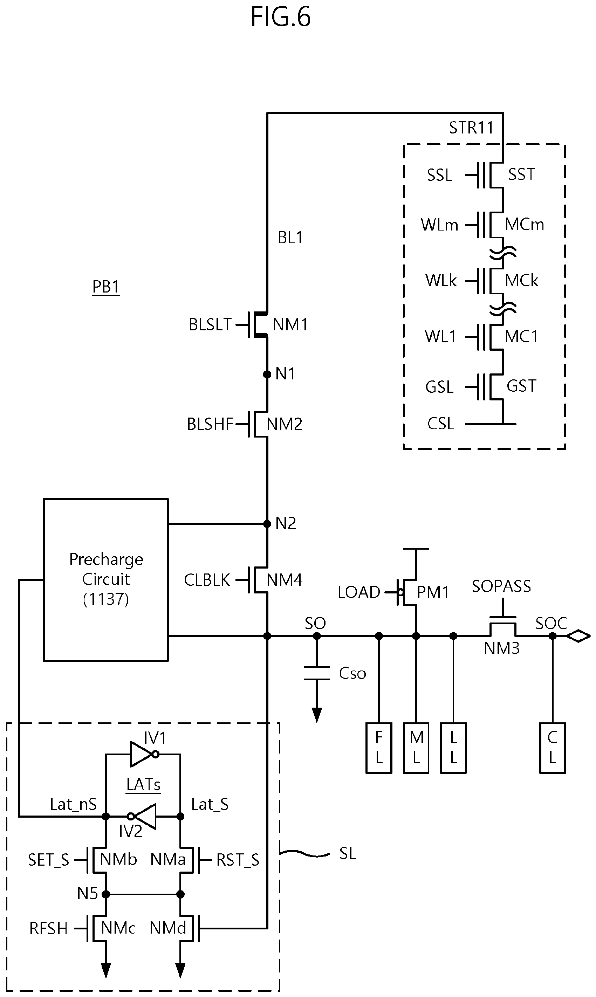

FIG. 6 is a circuit diagram illustrating an example of first page buffer PB1 shown in FIG. 4 according to some implementations. In FIG. 6, the first page buffer PB1 may be connected to the first bit line BL1. A cell string STR11 may be connected to the first bit line BL1.

The cell string STR11 may include a string select transistor SST, a plurality of memory cells MC1 to MCm, and a ground select transistor GST. The cell string STR11 may be connected between the first bit line BL1 and the common source line CSL. The cell string STR11 may include a string selection transistor SST selected by a string selection line SSL, first to m-th memory cells MC1 to MCm connected to the first to m-th word lines WL1 to WLm, and a ground selection transistor GST selected by the ground selection line GSL. The k-th memory cell MCk may be a selected memory cell, and the k-th word line WLk may be a selected word line.

The first page buffer PB1 may be connected to the cell string STR11 through the first bit line BL1. A first NMOS transistor NM1 may be included between the first bit line BL1 and the first node N1. The first NMOS transistor NM1 may be a bit line select transistor driven by the bit line select signal BLSLT. The bit line select transistor may be implemented as a high voltage transistor. The bit line select transistor may be disposed in the high voltage region.

A second NMOS transistor NM2 may be included between the first node N1 and the second node N2. The second NMOS transistor NM2 may be a bit line shut-off transistor driven by the bit line shut-off signal BLSHF.

A third NMOS transistor NM3 may be included between an SO node and an SOC node. The third NMOS transistor NM3 may be a sensing node pass transistor driven by the SOPASS signal. The SO node may have a capacitance Cso. A cache latch CL may be connected to the SOC node. The cache latch CL may be used to temporarily store data provided from the memory controller 1200.

A fourth NMOS transistor NM4 may be included between the second node N2 and the SO node. The fourth NMOS transistor NM4 may be a bit line connection transistor driven by the bit line connection control signal CLBLK.

A first PMOS transistor PM1 may be included between the SO node and the power terminal. The first PMOS transistor PM1 may be a precharge load transistor driven by the load signal LOAD. A pre-charge circuit 1137 may be included between the SO node and the second node N2. The precharge circuit 1137 may include a precharge transistor and a discharge transistor driven by a node Lat_nS.

A sensing latch SL, a force latch FL, a most significant bit latch ML, and a least significant bit latch LL may be connected to the SO node. The sensing latch SL may store data stored in the selected memory cell sMC or a sensing result of the threshold voltage of the selected memory cell sMC during a read or program verify operation. Also, the sensing latch SL may be used to apply a program bit line voltage or a program inhibit voltage to the first bit line BL1 during a program operation.

The force latch FL may be used to improve threshold voltage distribution during a program operation. The most significant bit latch ML and the least significant bit latch LL may be utilized to store data input from the outside during a program operation.

The sensing latch SL may include an S latch LATs connected between a node Lat_S and the Lat_nS node. The S latch LATs may include first and second inverters IV1 and IV2. The Lat_nS node may be connected to an input terminal of the first inverter IV1 and an output terminal of the second inverter IV2. The Lat_S node may be connected to an output terminal of the first inverter IV1 and an input terminal of the second inverter IV2.

An NMOS transistor NMa may be included between the Lat_S node and a fifth node N5. The NMa NMOS transistor may be used to reset the Lat_S node in response to an RST_S signal. When the Lat_S node is reset, the Lat_S node may be a ground level and may store data 0.

An NMOS transistor NMb may be included between the Lat_nS node and the fifth node N5. The NMb NMOS transistor may be used to set the Lat_S node in response to the SET_S signal. When the Lat_S node is set, the Lat_S node may be a power supply voltage level and may store data 1.

An NMOS transistor NMc may be included between the fifth node N5 and the ground terminal. The NMc NMOS transistor may adjust the voltage level of the fifth node N5 in response to the RFSH signal. An NMOS transistor NMd may be included between the fifth node N5 and the ground terminal. The NMd NMOS transistor may adjust the voltage level of the fifth node N5 in response to the voltage level of the SO node. The bit line control signals (e.g., BLSLT, BLSHF, etc.) may be provided from the control logic 1160.

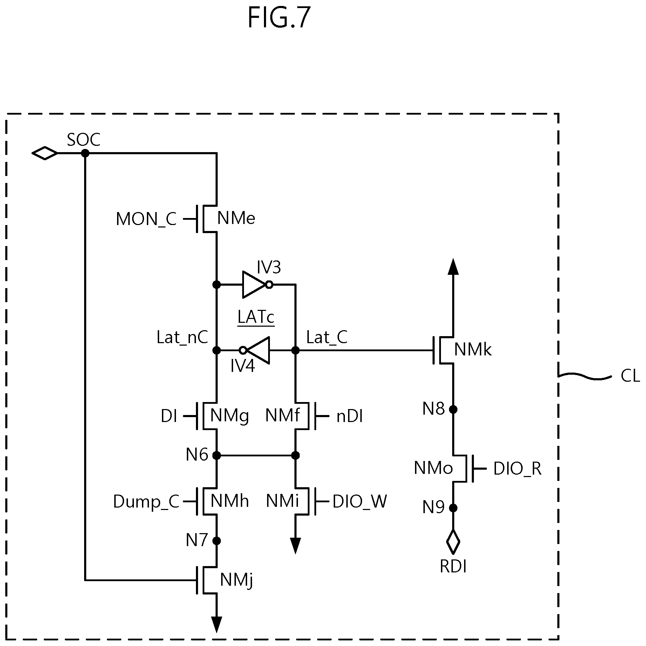

FIG. 7 is a circuit diagram illustrating an example of the cache latch CL illustrated in FIG. 6 according to some implementations. In FIG. 7, the cache latch CL may include a C latch LATc connected between a node Lat_C and a node Lat_nC.

The C latch LATc may include third and fourth inverters IV3 and IV4. The input terminal of the third inverter IV3 and the output terminal of the fourth inverter IV4 may be connected to the Lat_nC node. The output terminal of the third inverter IV3 and the input terminal of the fourth inverter IV4 may be connected to the Lat_C node.

An NMOS transistor NMe may be connected between the Lat_nC node and the SOC node. The NMe NMOS transistor may be a cache latch monitoring transistor driven by a signal MON_C.

An NMOS transistor NMf may be connected between the Lat_C node and a sixth node N6. The NMf NMOS transistor may be used to reset the Lat_C node in response to a signal nDI. When the Lat_C node is reset, the Lat_C node may be ground level and may store data 0.

An NMOS transistor NMg may be connected between the Lat_nC node and the sixth node N6. The NMg NMOS transistor may be used to set the Lat_C node in response to a signal DI. When the Lat_C node is set, the Lat_C node may be the power voltage level and may store data 1.

An NMOS transistor NMh may be connected between the sixth node N6 and a seventh node N7. The NMh NMOS transistor may be used to dump data stored in the C latch LATc to the force latch FL, the most significant bit latch ML, or the least significant bit latch LL in response to a signal Dump_C.

An NMOS transistor NMi may be connected between the sixth node N6 and the ground terminal. The NMi NMOS transistor may adjust the voltage level of the sixth node N6 in response to a signal DIO_W. An NMOS transistor NMj may be connected between the seventh node N7 and the ground terminal. The NMj NMOS transistor may control the voltage level of the seventh node N7 according to the voltage level of the SOC node.

An NMOS transistor NMk may be connected between an eighth node N8 and the ground terminal. The NMk NMOS transistor may be turned on or off according to the voltage level of the Lat_C node. When the Lat_C node is reset, a current path may be blocked between the eighth node N8 and the ground terminal. When the Lat_C node is set, a current path may be formed between the eighth node N8 and the ground terminal.

An NMOS transistor NMo may be connected between the eighth node N8 and a ninth node N9. The NMo NMOS transistor may perform a data input/output operation during a read operation in response to a signal DIO_R. The ninth node N9 may receive an RDI signal. The control signals (e.g., DI, nDI, Dump_C, etc.) of the cache latch CL may be provided from the control logic 1160.

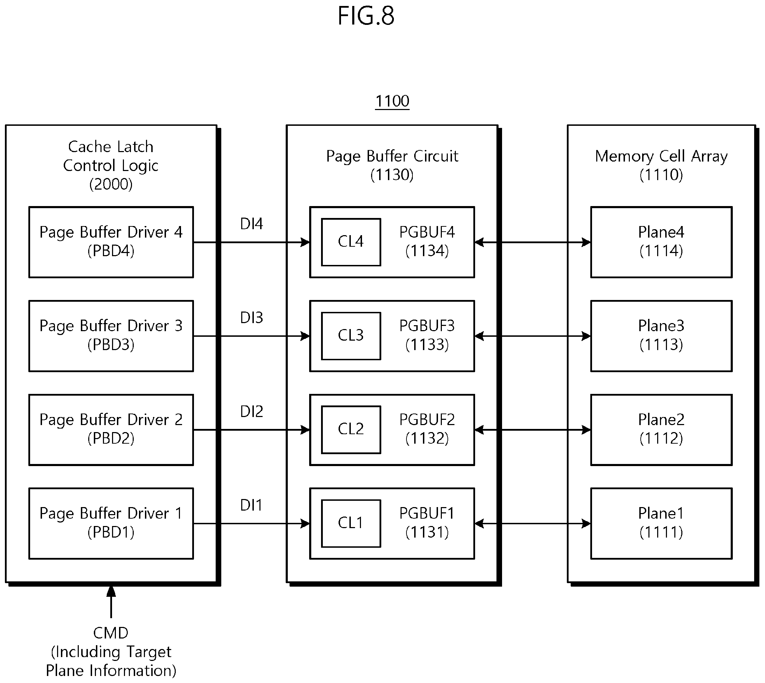

FIG. 8 is a block diagram illustrating an example of a cache latch initialization operation of a memory device according to some implementations. In FIG. 8, the memory device 1100 may include a memory cell array 1110, a page buffer circuit 1130, and a cache latch control logic 2000.

The memory cell array 1110 may include first to fourth planes 1111 to 1114. The page buffer circuit 1130 may include first to fourth page buffer circuits 1131 to 1134.

The first page buffer circuit (PGBUF1, 1131) may include first cache latches CL1, the second page buffer circuit (PGBUF2, 1132) may include second cache latches CL2, the third page buffer circuit (PGBUF3, 1133) may include third cache latches CL3, and the fourth page buffer circuit (PGBUF4, 1134) may include fourth cache latches CL4.

The cache latch control logic 2000 may include first to fourth page buffer drivers PBD1 to PBD4. The cache latch control logic 2000 may receive a command including target plane information and generate first to fourth cache latch initialization signals DI1 to DI4.

The first page buffer driver PBD1 may generate a first cache latch initialization signal DI1 and provide it to the first page buffer circuit (PGBUF1, 1131). The first page buffer circuit (PGBUF1, 1131) may receive the first cache latch initialization signal DI1 to initialize the first cache latches CL1. The first cache latch initialization signal DI1 may be a signal for resetting the Lat_nC node described in FIG. 7.

The second page buffer driver PBD2 may generate a second cache latch initialization signal DI2 and provide it to the second page buffer circuit (PGBUF2, 1132). The second page buffer circuit (PGBUF2, 1132) may receive the second cache latch initialization signal DI2 to initialize the second cache latches CL2.

The third and fourth page buffer drivers PBD3 and PBD4 may generate third and fourth cache latch initialization signals DI3 and DI4, respectively, and provide them to the third and fourth page buffer circuits 1133 and 1134, respectively. The third and fourth page buffer circuits 1133 and 1134 may receive third and fourth cache latch initialization signals DI3 and DI4, respectively, and initialize the third and fourth cache latches CL3 and CL4, respectively.

The cache latch control logic 2000 may receive a command including target plane information from the memory controller 1200 and selectively initialize the first to fourth cache latches CL1 to CL4. For example, if the command includes first plane information, the cache latch control logic 2000 may provide a first cache latch initialization signal DI1 to the first cache latches CL1 through the first page buffer driver PBD1.

If the command includes second plane information, the cache latch control logic 2000 may initialize the second cache latches CL2. If the command includes third plane information, the cache latch control logic 2000 may initialize the third cache latches CL3. If the command includes fourth plane information, the cache latch control logic 2000 may initialize the fourth cache latches CL4.

The command may include plane information relating to one or more planes. For example, the command may include first and second plane information. When the command includes first and second plane information, the cache latch control logic 2000 may activate the first and second page buffer drivers PBD1 and PBD2 and initialize the first and second cache latches CL1 and CL2.

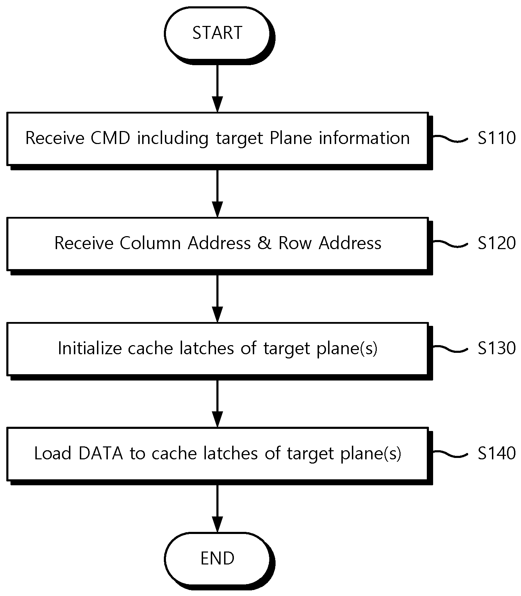

FIG. 9 is a flowchart illustrating an example of the cache latch initialization operation of the memory device illustrated in FIG. 8 according to some implementations. The cache latch initialization operation of the memory device 1100 may include a command input operation, a column address and row address input operation, an operation of initializing cache latches of target planes, and a data loading operation.

The data loading operation may be an operation of loading data into cache latches of the page buffer circuit 1130. Before performing the data loading operation, the memory device 1100 may receive a command including target plane information and selectively initialize cache latches.

In operation S110, the memory device 1100 may receive a command including target plane information from the memory controller 1200. The command may be input through input/output lines (see FIG. 2, IO1 to IOn). The command may be a data loading command for loading data into cache latches of the page buffer circuit 1130. The memory device 1100 may temporarily store data in the cache latches before programming data to the memory cell array 1110.

In operation S120, the memory device 1100 may receive addresses from the memory controller 1200. The addresses may include a column address CA and a row address RA. The row address may include a plane selection address for selecting one plane, a block selection address for selecting one memory block, and a word line selection address for selecting one word line.

In operation S130, the memory device 1100 may initialize cache latches corresponding to one or more target planes. The cache latch initialization operation may be performed while receiving addresses. The cache latch initialization operation may be performed through a cache latch initialization signal (see FIG. 7, DI). The cache latch initialization signal DI may be provided from the cache latch control logic 2000.

In operation S140, the memory device 1100 may receive data from the memory controller 1200 and load the data into the initialized cache latches. And then, the memory device 1100 may provide the data stored in the cache latches to the most significant bit latch ML or the least significant bit latch LL through a dump operation. The memory device 1100 may program the data stored in the page buffer circuit 1130 to the memory cells of the memory cell array 1110.

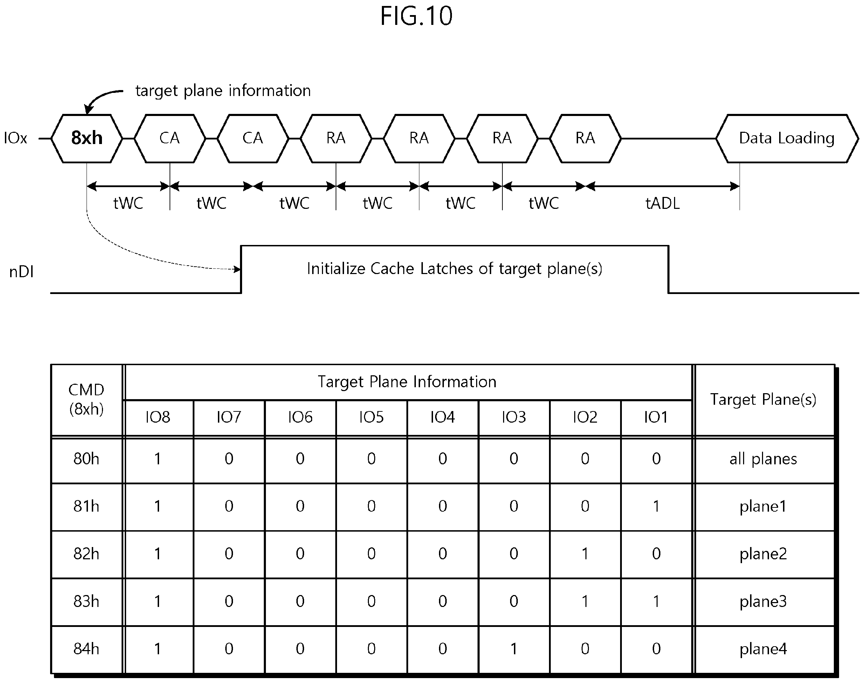

FIGS. 10 to 15 are timing diagrams illustrating examples of the cache latch initialization operation of the memory device illustrated in FIG. 9 according to some implementations. In FIG. 10, the memory device 1100 may receive a command, addresses, and data from the memory controller 1200 through input/output lines IOx. When the number of input/output lines IOx is 8, the memory device 1100 may receive input in byte units. One byte is a data unit composed of 8 bits.

The command may include target plane information. The target plane information is plane information for initializing cache latches of a specific plane during a cache latch initialization operation. For example, the target plane information may be 8xh. Hexa code 8 is 1000 in binary code, and hexa code x may include plain information.

When the memory device 1100 initializes a large number of cache latches simultaneously, a large peak current may occur. In order to reduce the peak current, it is necessary to divide number of cache latches into several units and initialize them sequentially. This may require a lot of initialization time.

The memory device 1100 has a limited time required to perform a program operation. In FIG. 10, the time from command input to data loading is fixed. 2 cycles of column address CA and 4 cycles of row address RA may be input during a time tWC, respectively. tWC stands for Write Cycle Time, which means the time it takes to write data in the memory device 1100. In FIG. 10, tADL stands for Address to Data Loading Time, which means the time from the rising edge of the write enable signal of the last address cycle to the rising edge of the write enable signal of the first data cycle in a program operation.

The time required for the memory device 1100 to perform a cache latch initialization operation is limited. The memory device 1000 may sequentially perform command input, address input, and data loading operations. If the address is input and the cache latches are initialized after confirming the plain address, the initialization operation may not be completed within the specified time.

For this reason, conventional memory devices start initializing the cache latches immediately after the command is input, and initialize the cache latches for all planes without confirming the address. Since conventional memory devices initialize the cache latches for all planes, a large peak current may occur. This problem may be more severe as the number of planes increases.

The cache latch control logic 2000 may receive target plane information during program operation, and selectively initialize cache latches according to the target plane information. The cache latch control logic 2000 may complete the program operation within a limited time and reduce peak current.

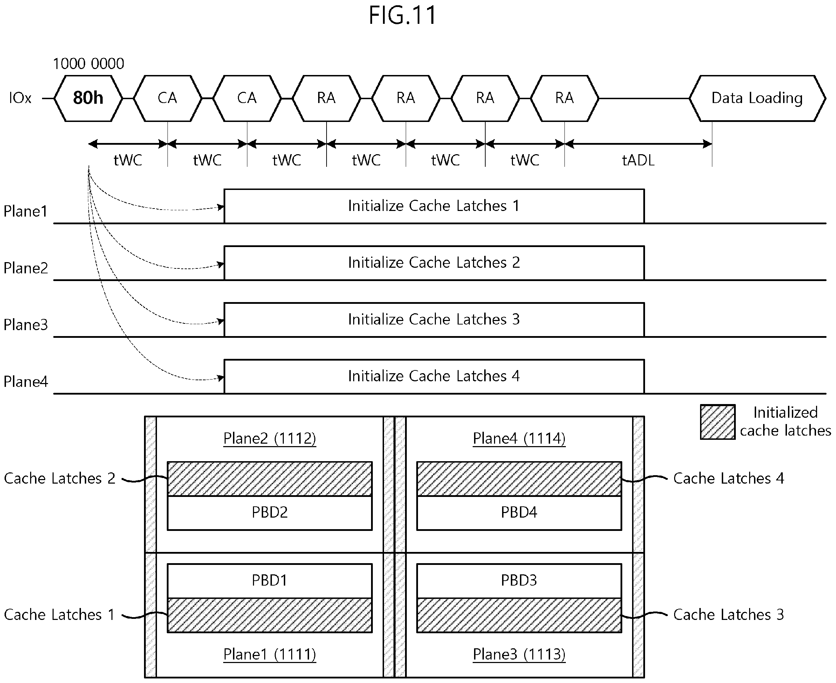

In FIGS. 10 and 11, when the hexa code x is 0, the binary code is 0000, and 80h may be a data loading command that uses all planes as target plane information. When the data loading command is 80h, the first to fourth cache latch initialization signals DI1 to DI4 may be provided to the first to fourth cache latches CL1 to CL4. The first to fourth cache latches CL1 to CL4 may be initialized by the first to fourth cache latch initialization signals DI1 to DI4, respectively.

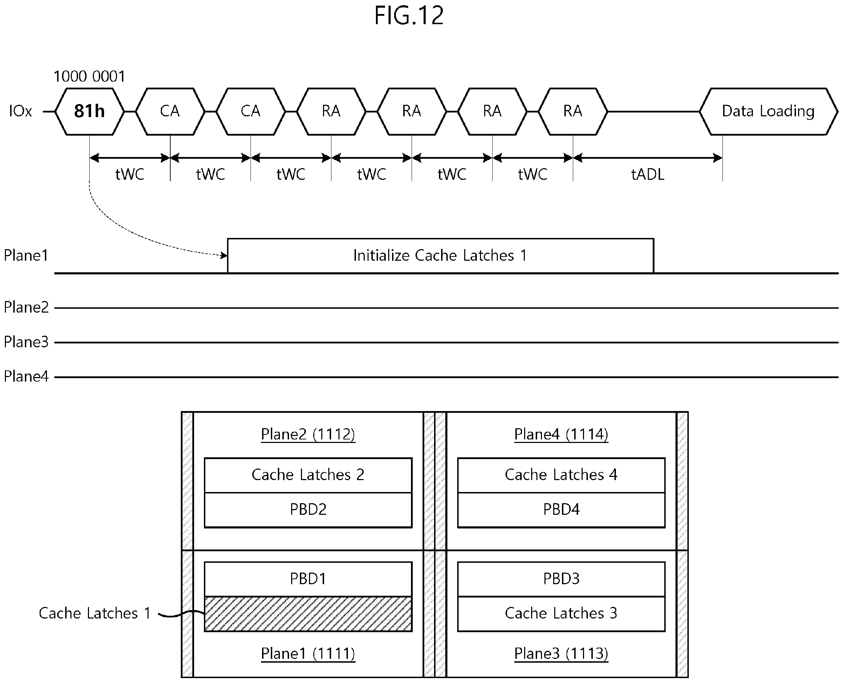

In FIGS. 10 and 12, when the hexa code x is 1, the binary code is 0001, and 81h may be a data loading command that uses the first plane as plane information. When the data loading command is 81h, the first cache latch initialization signals DI1 may be provided to the first cache latches CL1. The first cache latches CL1 may be initialized by the first cache latch initialization signal DI1.

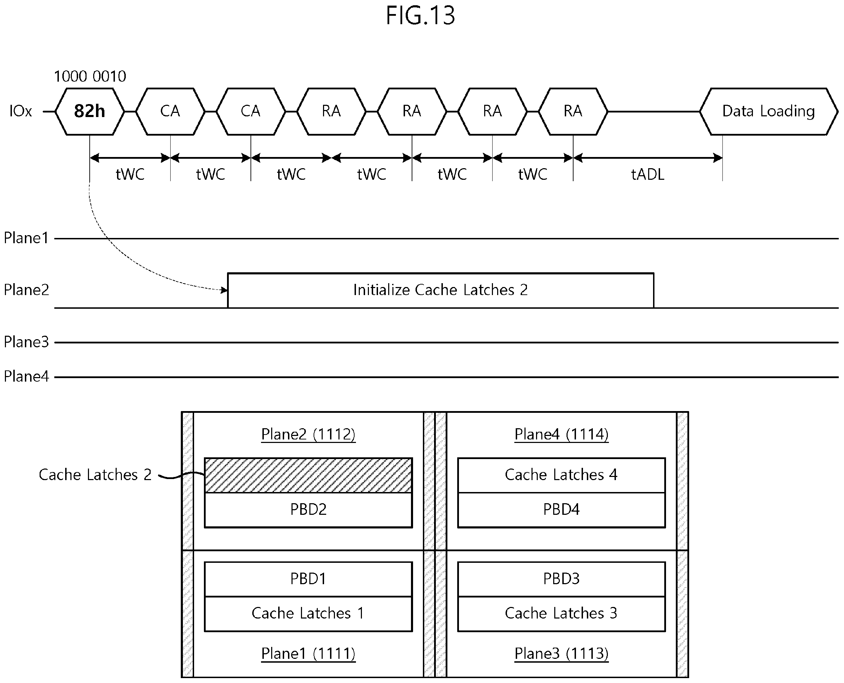

In FIGS. 10 and 13, when the hexa code x is 2, the binary code is 0010, and 82h may be a data loading command that uses the second plane as plane information. When the data loading command is 82h, the second cache latch initialization signals DI2 may be provided to the second cache latches CL2. The second cache latches CL2 may be initialized by the second cache latch initialization signal DI2.

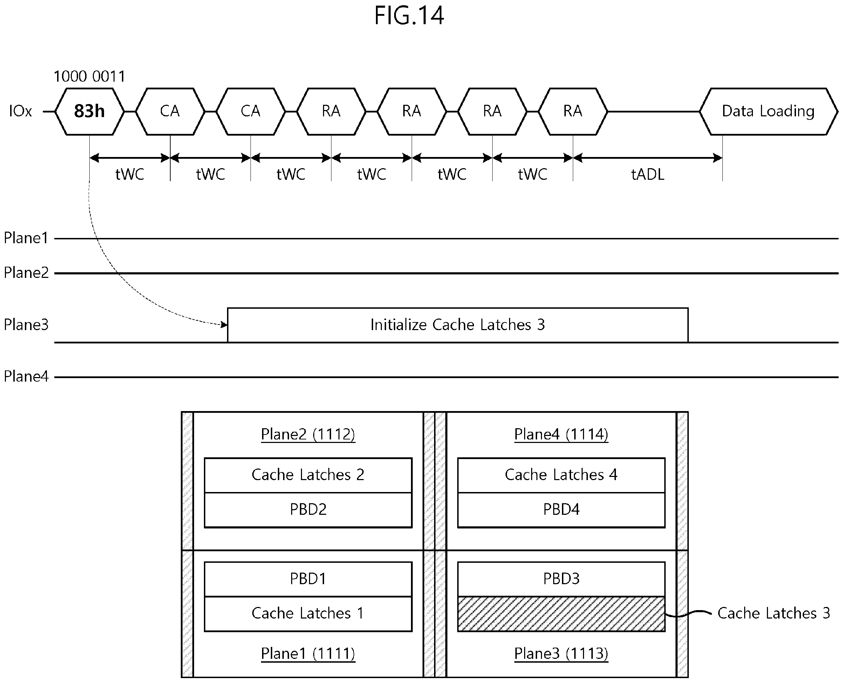

In FIG. 10 and FIG. 14, when the hexa code x is 3, the binary code is 0011, and 83h may be a data loading command that uses the third plane as plane information. When the data loading command is 83h, the third cache latch initialization signals DI3 may be provided to the third cache latches CL3. The third cache latches CL3 may be initialized by the third cache latch initialization signal DI3.

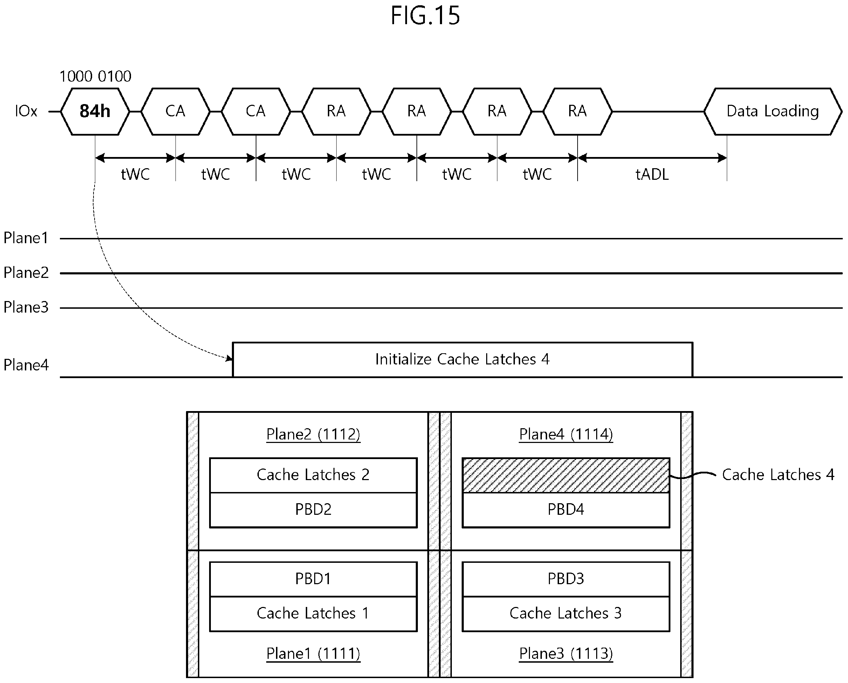

In FIG. 10 and FIG. 15, when the hexa code x is 4, the binary code is 0100, and 84h may be a data loading command that uses the fourth plane as plane information. If the data loading command is 84h, the fourth cache latch initialization signals DI4 may be provided to the fourth cache latches CL4. The fourth cache latches CL4 may be initialized by the fourth cache latch initialization signal DI4.

In FIG. 10, the memory device 1100 may load the data loading command 8xh, the column address CA, the row address RA, and the data through the input/output lines IOx. The data loading command 8xh may include target plane information. The data loading command 8xh may be matched one-to-one with each plane. For example, 80h may be matched with all planes, 81h may be matched with the first plane, 82h may be matched with the second plane, 83h may be matched with the third plane, and 84h may be matched with the fourth plane. The data loading command may have different commands for each plane.

The cache latch control logic 2000 may receive target plane information during program operation, and selectively initialize the first to fourth cache latches CL1 to CL4 according to the target plane information. The cache latch control logic 2000 may complete the cache latch initialization operation within a limited time and reduce peak current.

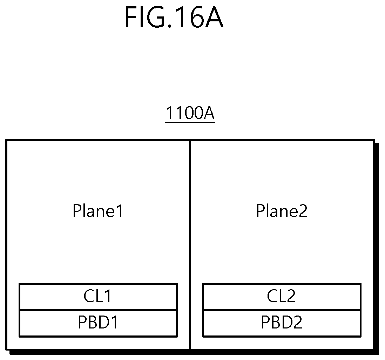

FIGS. 16A to 16D are block diagrams illustrating examples of memory devices including various numbers of planes according to some implementations. In FIGS. 16A to 16D, each of the memory devices 1100A to 1100D may include a plurality of planes, page buffer drivers matching each plane, and cache latches.

In FIG. 16A, the memory device 1100A may include two planes Plane1 and Plane2. The memory device 1100A may include a first page buffer driver PBD1 that correspond to the first plane and a second page buffer driver PBD2 matching the second plane. The first page buffer driver PBD1 may initialize the first cache latches CL1. The second page buffer driver PBD2 may initialize the second cache latches CL2.

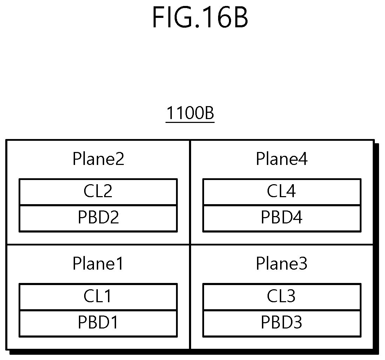

In FIG. 16B, the memory device 1100B may include four planes Plane1 to Plane4. The memory device 1100B may include first to fourth page buffer drivers PBD1 to PBD4 that correspond to the first to fourth planes, respectively. The first to fourth page buffer drivers PBD1 to PBD4 may initialize the first to fourth cache latches CL1 to CL4, respectively.

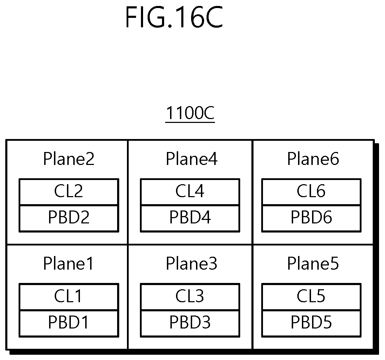

In FIG. 16C, the memory device 1100C may include six planes Plane1 to Plane6. The memory device 1100C may include first to sixth page buffer drivers PBD1 to PBD6 that correspond to the first to sixth planes, respectively. Each of the first to sixth page buffer drivers PBD1 to PBD6 may initialize the first to sixth cache latches CL1 to CL6, respectively.

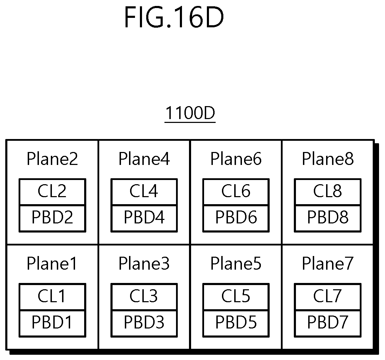

In FIG. 16D, the memory device 1100D may include eight planes Plane1 to Plane8. The memory device 1100D may include first to eighth page buffer drivers PBD1 to PBD8 that correspond to the first to eighth planes, respectively. Each of the first to eighth page buffer drivers PBD1 to PBD8 may initialize the first to eighth cache latches CL1 to CL8, respectively.

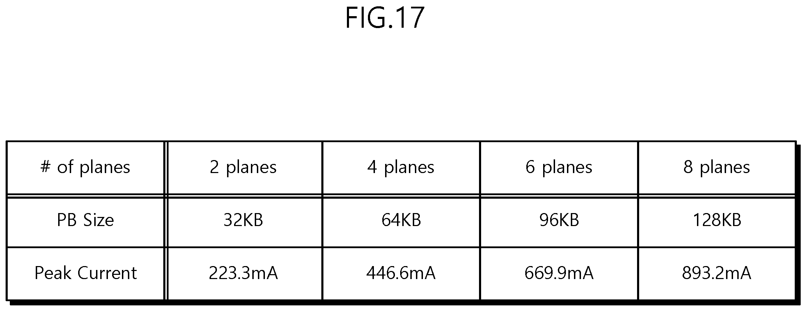

FIG. 17 is a diagram illustrating examples of peak currents generated during a program operation of the memory devices illustrated in FIGS. 16A to 16D according to some implementations. The memory cell array may include a plurality of planes and page buffers matching each plane. The number of page buffers may also increase proportionally as the number of planes increases.

According to some implementations, when the number of planes is 2, the number of page buffers may be 32 KB. When the number of planes is 4, the number of page buffers may be 64 KB. When the number of planes is 6, the number of page buffers may be 96 KB. When the number of planes is 8, the number of page buffers may be 128 KB. In this case, the peak current generated by the initialization of the cache latches may increase in proportion to the number of planes or the number of page buffers.

In FIG. 17, when the number of planes is 2, the peak current may be 223.3 mA during the cache latch initialization operation. When the number of planes is 4, the peak current may be 446.6 mA. When the number of planes is 6, the peak current may be 669.9 mA. When the number of planes is 8, the peak current may be 893.2 mA.

In this case, a method of increasing the initialization allowance time may be considered to reduce the increased peak current. However, if the initialization allowance time is increased, the time required for the program operation of the memory device 1100 may increase. It may be impossible to avoid a degradation in the performance of the entire program operation.

The memory device 1100 may complete the cache latch initialization operation within the initialization allowance time and reduce the peak current by receiving target plane information during a program operation and selectively initializing cache latches according to the target plane information.

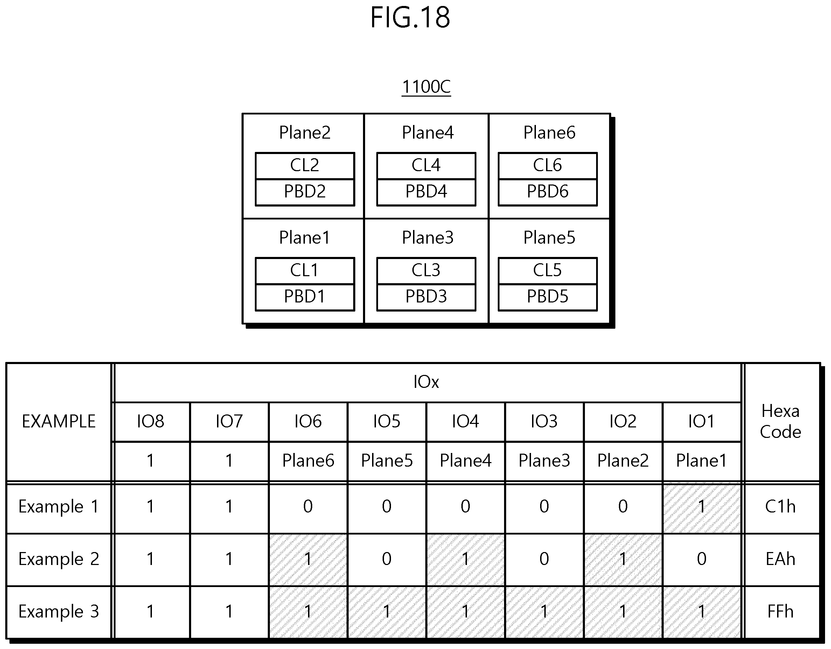

FIGS. 18 to 21 are diagrams illustrating examples of the cache latch initialization operation of the memory device illustrated in FIG. 16C according to some implementations. In FIG. 18, the memory device 1100C may include first to sixth planes Plane1 to Plane6. The memory device 1100C may include first to sixth page buffer drivers PBD1 to PBD6 and first to sixth cache latches CL1 to CL6 corresponding to the first to sixth planes, respectively.

The memory device 1100C may perform a cache latch initialization operation by matching target plane information included in the command with the input/output lines IOx. For example, the first input/output line IO1 may be matched with the first plane. The second input/output line IO2 may be matched with the second plane. The third to sixth input/output lines IO3 to IO6 may be matched with the third to sixth planes, respectively. The seventh and eighth input/output lines IO7 and IO8 may be set to 1.

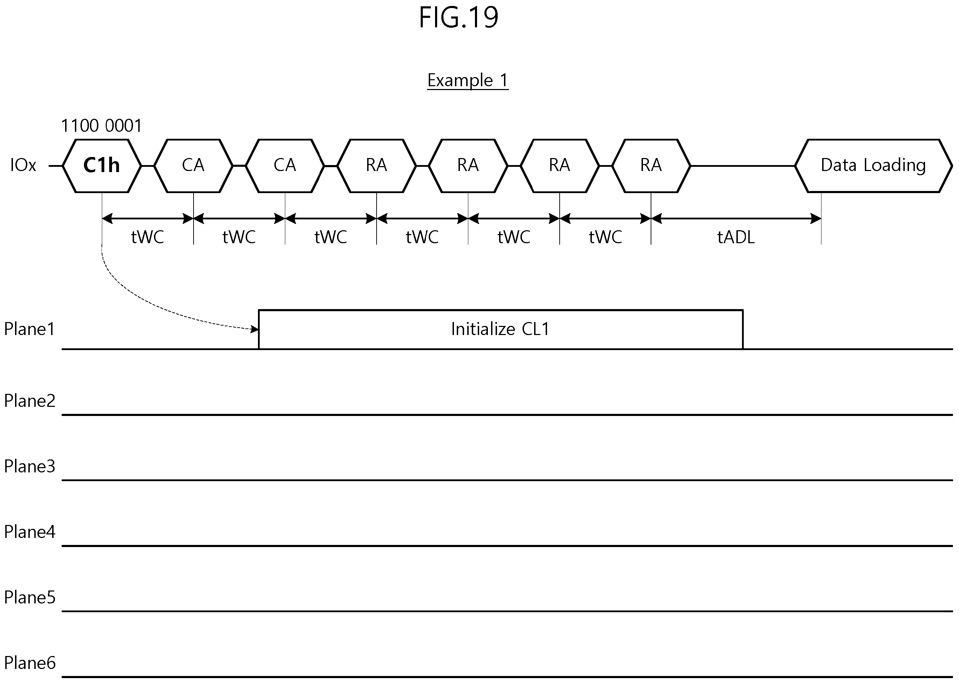

In FIGS. 18 and 19, with reference to Example 1, the target plane may be the first plane. The first plane may be matched with the first input/output line IO1. When the target plane is the first plane, IO[8:1] may be 1100 0001, and the hexa code may be C1h. When the data loading command is C1h, the first cache latches CL1 matching the first plane may be initialized.

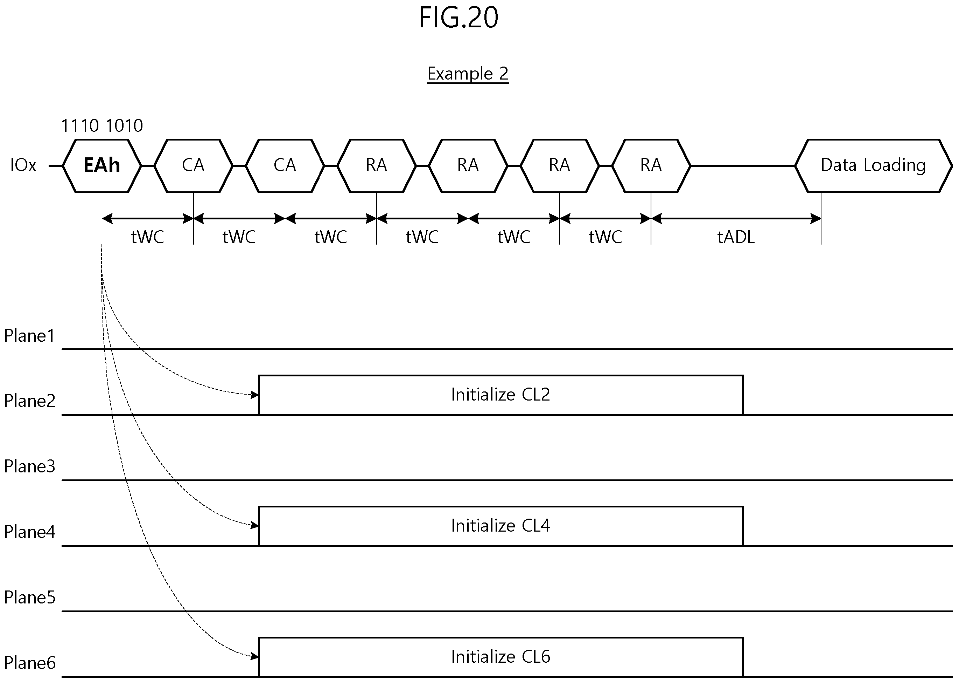

In FIGS. 18 and 20, with reference to Example 2, the target planes may be the second plane, the fourth plane, and the sixth plane. The second plane may be matched with the second input/output line IO2, the fourth plane may be matched with the fourth input/output line IO4, and the sixth plane may be matched with the sixth input/output line IO6. When the target planes are the second, fourth, and sixth planes, IO[8:1] may be 1110 1010, and the hexa code may be EAh. When the data loading command is EAh, the second, fourth, and sixth cache latches CL2, CL4, and CL6 matching the second, fourth, and sixth planes may be initialized.

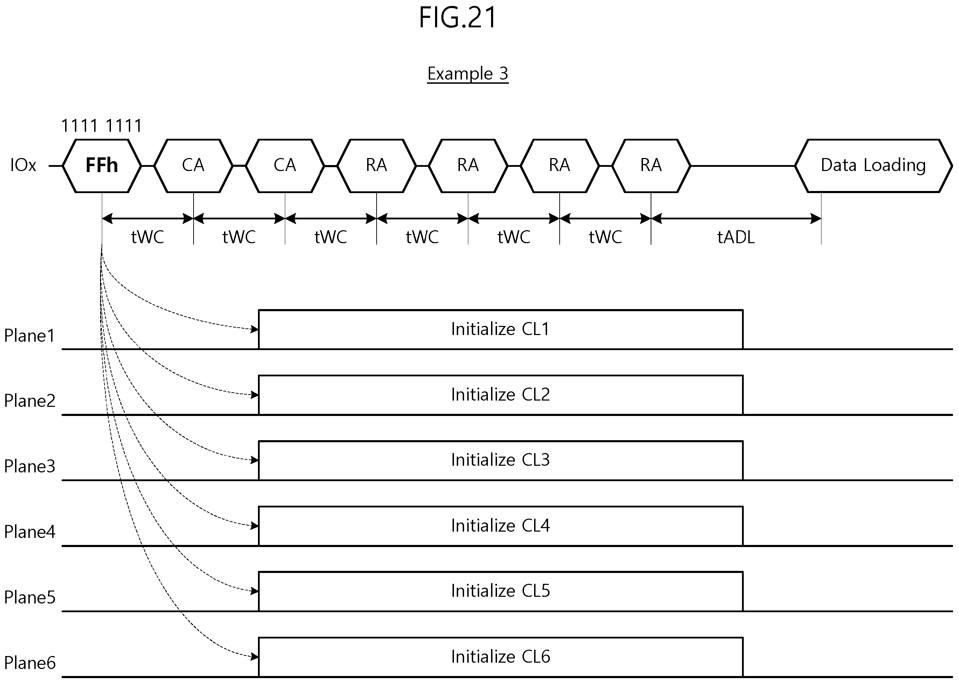

In FIGS. 18 and 21, with reference to Example 3, the target planes may be the first to sixth planes. When the target planes are the first to sixth planes, IO[8:1] may be 1111 1111, and the hexa code may be FFh. When the data loading command is FFh, the first to sixth cache latches CL1 to CL6 matching the first to sixth planes may all be initialized.

In FIG. 18, the cache latch control logic 2000 may receive a data loading command including target plane information during a program operation, and may selectively initialize the first to sixth cache latches CL1 to CL6 according to the target plane information. The data loading command may match the command bits of each input/output line with each plane. The cache latch control logic 2000 may complete the cache latch initialization operation within a limited time, and may reduce the peak current.

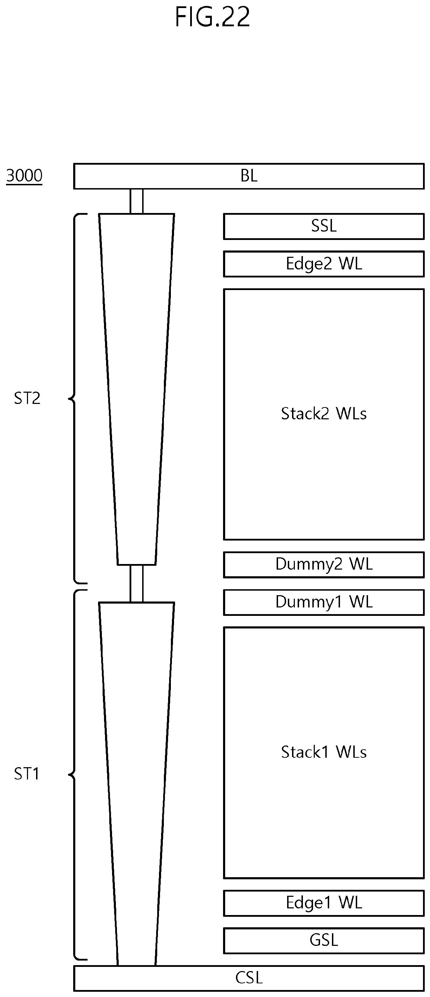

FIG. 22 is a diagram illustrating an example of a memory device having a multi-stack structure according to some implementations. The memory device with a multi-stack structure may perform the cache latch initialization operation described above. In FIG. 22, the memory device 3000 may have a first stack ST1 and a second stack ST2. The first stack ST1 may be located at the bottom, and the second stack ST2 may be located at the top.

A pillar of the memory device 3000 may be formed by bonding the first and second stacks ST1 and ST2. A plurality of dummy word lines (e.g., Dummy1 WL and Dummy2 WL) may be included at junctions of the first and second stacks ST1 and ST2. The first stack ST1 may be positioned between the common source line CSL and the first dummy word line Dummy1 WL. The second stack ST2 may be positioned between the second dummy word line Dummy2 WL and the bit line BL.

The first stack ST1 may include a ground selection line GSL, a first edge word line Edge1 WL, and first stack word lines Stack1 WLs. The second stack ST2 may include second stack word lines Stack2 WLs and second edge word lines Edge2 WL. Memory cells connected to the first and second edge word lines Edge1 WL and Edge2 WL may store bit data different from the other memory cells. For example, memory cells connected to the first and second edge word lines Edge1 WL and Edge2 WL may be single-level cells (SLC) or multi-level cells (MLC), and memory cells connected to the other word lines may be triple-level cells (TLC) or quad-level cells (QLC).

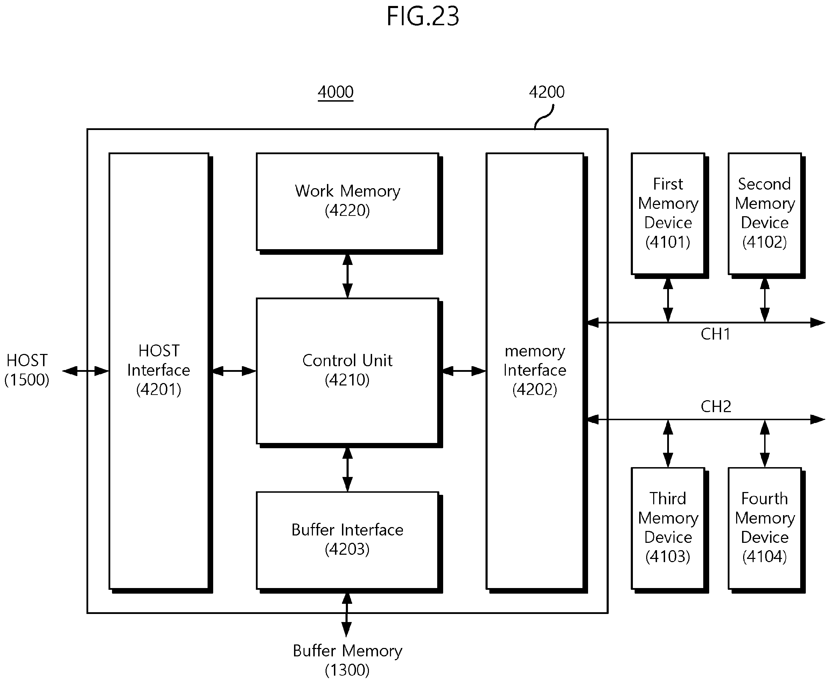

FIG. 23 is a block diagram illustrating an example in which a storage device is implemented with a solid state drive (SSD) according to some implementations. In FIG. 23, an SSD 4000 may include a plurality of memory devices 4101 to 4104 and an SSD controller 4200.

The first and second memory devices 4101 and 4102 may be connected with the SSD controller 4200 through a first channel CH1. The third and fourth memory devices 4103 and 4104 may be connected with the SSD controller 4200 through a second channel CH2. The number of channels connected with the SSD controller 4200 may be two or more. The number of memory devices connected with one channel may be two or more.

The SSD controller 4200 may include a host interface 4201, a memory interface 4202, a buffer interface 4203, a control unit 4210, and a work memory 4220. The SSD controller 4200 may be connected with a host 1500 through the host interface 4201. Depending on a request of the host 1500, the SSD controller 4200 may write data in the corresponding memory device or may read data from the corresponding memory device.

The SSD controller 4200 may be connected with the plurality of memory devices 4101 to 4104 through the memory interface 4202 and may be connected with a buffer memory 1300 through the buffer interface 4203. The memory interface 4202 may provide data, which are temporarily stored in the buffer memory 1300, to the plurality of memory devices through the channels CH1 and CH2. The memory interface 4202 may transfer the data read from the plurality memory devices 4101 to 4104 to the buffer memory 1300.

The control unit 4210 may analyze and process the signal received from the host 1500. The control unit 4210 may control the host 1500 or the plurality memory devices 4101 to 4104 through the host interface 4201 or the memory interface 4202. The control unit 4210 may control operations of the plurality memory devices 4101 to 4104 by using firmware for driving the SSD 4000.

The SSD controller 4200 may manage data to be stored in the plurality of memory devices 4101 to 4104. In a sudden power-off event, the SSD controller 4200 may back up the data stored in the work memory 4220 or the buffer memory 1300 to the plurality of memory devices 4101 to 4104.

According to the present disclosure, a memory device may complete a cache latch initialization operation within an initialization allowable time and reduce peak current by receiving a command including target plane information during a program operation and selectively initializing cache latches according to the target plane information. While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A memory device (1100), comprising:
a memory cell array (1110) including a first plane (1111) and a second plane (1112);
a page buffer circuit (1130) including first cache latches (CL1) configured to store data in the first plane (1111) and second cache latches (CL2) configured to store data in the second plane (1112); and
input/output lines (IO1...IOn) configured to receive a command and addresses from a memory controller (1200),
wherein the command includes target plane information configured to initialize at least one of the first cache latches (CL1) and the second cache latches (CL2).

2. The memory device (1100) of claim 1, wherein the memory device (1100) is configured to initialize cache latches of a target plane according to the command.

3. The memory device (1100) of claim 2, further comprising a cache latch control logic (2000) configured to provide, to the page buffer circuit (1130), a first cache latch initialization signal (DI1) for initializing the first cache latches (CL1) and a second cache latch initialization signal (DI2) for initializing the second cache latches (CL2).

4. The memory device (1100) of claim 3, wherein the command comprises different commands for each of the first plane (1111), the second plane (1112), and the target plane.

5. The memory device (1100) of claim 3 or 4, wherein the command is configured to be one-to-one matched with the first plane (1111), the second plane (1112), and the target plane.

6. The memory device (1100) of any one of claims 3 to 5, wherein command bits of each input/output line (IO1...IOn) are configured to be matched with the first plane (1111), the second plane (1112), and the target plane.

7. The memory device (1100) of any preceding claim,
wherein the first cache latches (CL1) are configured to be initialized based on a command bit of a first input/output line (IO1) being 1, and
wherein the second cache latches (CL2) are configured to be initialized based on a command bit of a second input/output line (IO1) being 1.

8. The memory device (1100) of any preceding claim, wherein the first cache latches (CL1) and the second cache latches (CL2) are both configured to be initialized based on command bits of first and second input/output lines (IO1, IO2) all being 1.

9. The memory device (1100) of any preceding claim when dependent on claim 3, wherein the cache latch control logic (2000) includes:
a first page buffer driver (PBD1) configured to generate the first cache latch initialization signal (DI1) and provide the first cache latch initialization signal (DI1) to the first cache latches (CL1) according to the target plane information; and
a second page buffer driver (PBD2) configured to generate the second cache latch initialization signal (DI2) and provide the second cache latch initialization signal (DI2) to the second cache latches (CL2) according to the target plane information.

10. The memory device (1100) of any preceding claim when dependent on claim 3, further comprising:
third to n-th planes; and
third to n-th cache latches,
wherein the cache latch control logic (2000) is configured to initialize the first cache latches (CL1), the second cache latches (CL2), and the third to n-th cache latches according to the command.

11. A memory controller (1200) for controlling a memory device (1100),
the memory device (1100) comprising:
a memory cell array (1110) including a first plane (1111) and a second plane (1112);
a page buffer circuit (1130) including first cache latches (CL1) configured to store data in the first plane (1111) and second cache latches (CL2) configured to store data in the second plane (1112); and
a cache latch control logic (2000) configured to provide, to the page buffer circuit (1130), a first cache latch initialization signal (DI1) for initializing the first cache latches (CL1) and a second cache latch initialization signal (DI2) for initializing the second cache latches (CL2),
wherein the memory controller (1200) is configured to provide a command comprising target plane information to the memory device (1200) during a program operation, and
wherein at least one of the first cache latches (CL1) and the second cache latches (CL2) are configured to be selectively initialized according to the target plane information.

12. The memory controller (1200) of claim 11, wherein the command is configured to have different commands for each of the first plane (1111) and the second plane (1112).

13. The memory controller (1200) of claim 11 or 12, wherein the command is configured to be one-to-one matched with the first plane (1111) and the second plane (1112).

14. The memory controller (1200) of any one of claims 11 to 13, wherein command bits of input/output lines (IO1...IOn) are matched with the first plane (1111) and the second plane (1112).

15. The memory controller (1200) of any one of claims 11 to 14,
wherein the first cache latches (CL1) are configured to be initialized based on a command bit of a first input/output line (IO1) being 1, and
wherein the second cache latches (CL2) are configured to be initialized based on a command bit of a second input/output line (IO2) being 1.
